Europäisches Patentamt

(19) European Patent Office

Office européen des brevets

(11) Veröffentlichungsnummer: **0 031 094**
**B1**

(12) **EUROPÄISCHE PATENTSCHRIFT**

(45) Veröffentlichungstag der Patentschrift:
28.03.84

(51) Int. Cl.³: **G 11 C 11/40**

(21) Anmeldenummer: **80107831.2**

(22) Anmeldetag: **11.12.80**

(54) **Integrierbare Halbleiterspeicherzelle**

(30) Priorität: **21.12.79 DE 2951915**

(43) Veröffentlichungstag der Anmeldung:
**01.07.81 Patentblatt 81/26**

(45) Bekanntmachung des Hinweises auf die Patenterteilung:
**28.03.84 Patentblatt 84/13**

(84) Benannte Vertragsstaaten:
**FR GB IT**

(56) Entgegenhaltungen:
**DE - A - 2 204 562**
**DE - A - 2 739 283**
**DE - A - 2 757 762**

**IBM TECHNICAL DISCLOSURE BULLETIN, Band 14, Nr. 6, November 1971, NEW YORK (US), MOORE:"Schottky Barrier Diode Storage Cell", Seite 1683**
**IEEE JOURNAL OF SOLID-STATE CIRCUITS, Band SC-12, Nr. 2, April 1977, NEW YORK (US), MIDDELHOEK et al.: "Polycristalline Silicon as a Diffusion Source and Interconnect Layer in I2L Realizations", Seiten 135-138**

(73) Patentinhaber: **SIEMENS AKTIENGESELLSCHAFT, Berlin und München Wittelsbacherplatz 2, D-8000 München 2 (DE)**

(72) Erfinder: **Kranzer, Ditmar, Dr., Theodor-Heuss-Strasse 8, D-8011 Putzbrunn (DE)**
Erfinder: **Rydval, Peter, Dipl.-Ing., Hirtentäschelweg 11, D-8000 München 70 (DE)**
Erfinder: **Werner, Wolfgang, Dr., Lorenzonlstrasse 66, D-8000 München 90 (DE)**

Integrierbare Halbleiterspeicherzelle

Die Erfindung betrifft eine integrierbare Halbleiterspeicherzelle mit zwei einander gleichen Bipolartransistoren, die derart geschaltet sind, dass ihre Kollektoren in Serie mit je einem eine nichtlineare Strom-Spannungscharakteristik aufweisenden Schaltungsteil an ein gemeinsames erstes elektrisches Versorgungspotential gelegt und ausserdem jeweils mit der Basis des jeweils anderen dieser beiden Transistoren verbunden sind, bei der ferner je ein Emitter dieser beiden Transistoren an einen gemeinsamen Anschluss für ein zweites Versorgungspotential gelegt und je ein weiterer Emitter zur Signalsteuerung der Halbleiterspeicherzelle vorgesehen ist, bei der ausserdem der zwischen dem Kollektor jedes der beiden Transistoren und dem das erste elektrische Versorgungspotential führenden Eingang liegende Schaltungsteil in allen Punkten seiner Strom-Spannungscharakteristik einen stärkeren Anstieg als die entsprechenden Punkte der Strom-Spannungscharakteristik des Emitter-Basis-Übergangs der beiden Transistoren hat.

Eine solche Halbleiterspeicherzelle ist in der DE-A-2 739 283 beschrieben. Jeder der beiden zwischen den Kollektoren der kreuzgekoppelten Transistoren der Speicherzelle liegenden Schaltungsteile mit nichtlinearer Strom-Spannungscharakteristik ist dort durch die Serienschaltung zweier Schottkydioden gegeben, wobei die Kathode der einen Diode jeweils mit dem Kollektor des zugehörigen Transistors und mit der Basis des anderen Transistors unmittelbar verbunden ist, während die Anode der zweiten Schottkydiode an dem das erste Versorgungspotential der Speicherzelle liefernden gemeinsamen Anschluss liegt. Damit wird ein Verhalten der Speicherzelle erreicht, das in bezug auf die Grösse der Spannung U zwischen den Kollektoren der beiden Transistoren (also in bezug des Spannungshubes) einer Speicherzelle entspricht, deren nichtlineares Schaltungsglied aus der Parallelschaltung einer Diode in Flussrichtung mit einem Widerstand besteht und dementsprechend grösser als die nur mit einer Diode, oder Schottkydiode als nichtlineares Glied erreichbarer Spannungshub ist.

Zum anderen ist ein definierter Arbeitspunkt und damit eine definierte Umschaltschwelle der Speicherzelle aus dem einen in den anderen Zustand gesichert. Diese und weitere Vorteile sind in der DE-A-2 739 283 dargestellt.

Einer der wichtigsten Gesichtspunkte bei der Herstellung monolitisch integrierter Halbleiterschaltungen ist einmal die Ersparnis an Chip-Fläche und dann die Einsparung von Fertigungsschritten, d.h. es ist hier das Ziel, eine der beiden Schottkydioden pro nichtlinearen Schaltungsteil einzusparen.

Bei einer Ausbildung der Speicherzelle, wie sie in der DE-A-2 204 562 beschrieben ist, hat man in den beiden Zweigen der Speicherzelle ebenfalls jeweils nur eine Schottkydiode, über deren spezifische Eigenschaften, insbesondere deren [U/I]-Kennlinie sowie deren Struktur keine näheren Einzelheiten angegeben sind. Die beiden Schottkydioden sind in Serie mit einem gemeinsamen Widerstand geschaltet, der ebenfalls zu der betreffenden Speicherzelle gehört. Angestrebt ist bei der dort beschriebenen Speicherzelle, dass sie schnell arbeitet, was auch eines der Ziele der vorliegenden Erfindung ist. Der bei der bekannten Zelle jedoch benötigte Widerstand bedingt jedoch bei einer monolithischen Realisierung einen erheblichen Platzbedarf, so dass es anzustreben ist, ohne einen solchen Widerstand auszukommen. In diesem Zusammenhang kann noch auf die US-A-3 886 531 hingewiesen werden, die ebenfalls eine Speicherzelle mit nur zwei Schottkydioden behandelt. Hier ist jedoch im Interesse eines einwandfreien Funktionierens die Speicherzelle mit dem Emitter je eines ihrer beiden Transistoren nicht unmittelbar sondern über eine Stromquelle an den zugehörigen Anschluss für das untere Versorgungspotential der Zelle angeschlossen, so dass auch hier ein erheblicher Platzbedarf für die einzelne Speicherzelle gegeben ist.

Demgemäss ist bei einer der Erfindung entsprechenden Halbleiterspeicherzelle vorgesehen, dass die beiden Schaltungsteile mit nichtlinearer Strom-Spannungscharakteristik jeweils nur aus einer Schottkydiode bestehen, deren aus einer Metallelektrode bestehende Anode zusammen mit der Anode der den anderen nichtlinearen Schaltungsteil bildenden Schottkydiode an dem das erste Versorgungspotential liefernden gemeinsamen Anschluss und deren Kathode am Kollektor jeweils des einen und an der Basis des anderen Transistors liegt, und dass die Kathode der jeweiligen Schottkydiode aus polykristallinem Halbleitermaterial erzeugt wird.

Durch die Verwendung einer aus polykristallinem Halbleitermaterial, insbesondere polykristallinem Silicium, bestehenden Unterlage für den die Schottkydiode bildenden Schottkykontakt erreicht man eine wesentlich höhere Steigung der Strom-Spannungskennlinie der Schottkydiode als im Falle der für diesen Einsatz allgemein üblichen Schottkydiode auf monokristalliner Unterlage, die zum Beispiel in der US-A-3 886 531 beschrieben ist. Durch die Erfindung wird der durch diesen Stand der Technik erzielte Vorteil der raschen Schaltgeschwindigkeit der Speicherzelle gesichert oder sogar noch gesteigert.

An sich könnte man als nichtlinearen Schaltungsteil einer Speicherzelle von dem genannten Typ auch eine sogenannte Punch-Through-Diode verwenden, die — im Gegensatz zu einer Schottkydiode auf monokristalliner Unterlage oder einer normalen Diode mit pn-Übergang — ebenfalls eine sehr steile Strom-Spannungscharakteristik hat. Jedoch führen der hohe Serienwiderstand und die Speichereigenschaften einer solchen pn-Diode zu ungünstigen dynamischen Eigenschaften der Speicherzelle. Diese Nachteile werden ebenfalls bei Anwendung der Lehre der Erfindung vermieden.

Die Herstellung der als nichtlinearer Schaltungsteil bei einer Speicherzelle gemäss der Erfindung anzuwendenden Schottkydioden geschieht vorteilhaft unter Verwendung des in der DE-A-2 757 762 oder GB-A-2 011 167 beschriebenen Verfahrens. Dort handelt es sich um eine monolitische Kombination zweier komplementärer Bipolartransistoren, von denen der eine als Lateraltransistor, der andere als Vertikaltransistor nebeneinander an der Oberfläche eines Halbleitereinkristalls erzeugt und derart ausgebildet sind, dass die Basiszone des Vertikaltransistors mit der Kollektorzone des Lateraltransistors zusammenfällt, bei der ausserdem mindestens eine zum Vertikaltransistor gehörende und gegen die Basiszone dieses Transistors durch einen pn-Übergang abgegrenzte Kollektorzone aus einkristallinem Halbleitermaterial und als Kollektorelektrode ein Schottky-Kontakt vorgesehen ist. Diese Anordnung ist dadurch gekennzeichnet, dass die einkristalline Kollektorzone des Vertikaltransistors durch eine Schicht aus polykristallinem Halbleitermaterial vom Leitungstyp der einkristallinen Kollektorzone erweitert und die als Schottkykontakt ausgebildete Kollektorelektrode an der Oberfläche der polykristallinen Halbleiterschicht erzeugt ist.

Dabei handelt es sich um sogenannte $I^2L$-Schaltungen, mit einem oder mehreren durch die Kollektoren der Vertikaltransistoren gegebenen Signalausgängen. Dabei kann die aus polykristallinem Silicium bestehende Trägerschicht zum Teil auch auf einer an der Oberfläche des den übrigen Teil der Schaltung enthaltenden Halbleiterbereichs erzeugten Isolierschicht, insbesondere $SiO_2$-Schicht, und somit ausserhalb der für die betreffende Speicherzelle benötigten Chip-Fläche erzeugt werden. Da diese Isolierschicht im übrigen auch als Träger der elektrischen Verbindungen zwischen benachbarten Speicherzellen dient und sich auf einem lediglich für die Isolation zwischen benachbarten Speicherzellen vorgesehenen Bereich des die Speicherschaltung aufnehmenden Chips befindet, wird der Vorteil der Platzersparnis bei einer solchen Ausgestaltung einer $I^2L$-Logik ohne weiteres verständlich.

Derselbe Vorteil lässt sich auch bei Speicherzellen entsprechend der Erfindung erreichen, da auch hier die beiden Schottkydioden an der Oberfläche einer aus polykristallinem Silicium bestehenden Halbleiterschicht erzeugt weden und sich eine solche Schicht ohne Schwierigkeit auch an der Oberfläche einer, zum Beispiel aus $SiO_2$ bestehenden Isolierschicht durch thermisches Abscheiden von dotiertem Silicium aus der Gasphase erzeugen lässt.

Wesentlich für die vorliegende Erfindung ist jedoch die in der GB-A-2 011 167 bzw. der DE-A-2 757 762 nirgends zum Ausdruck gebrachte Tatsache, dass eine auf einer Unterlage aus polykristallinem Silicium erzeugte Schottky-Diode, eine wesentlich höhere Steilheit ihrer U/I-Kennlinie aufweist, als dies der Fall wäre, wenn die Schottkydiode auf einer Unterlage aus monokristallinem Silicium unter sonst gleichen Bedingungen erzeugt worden wäre.

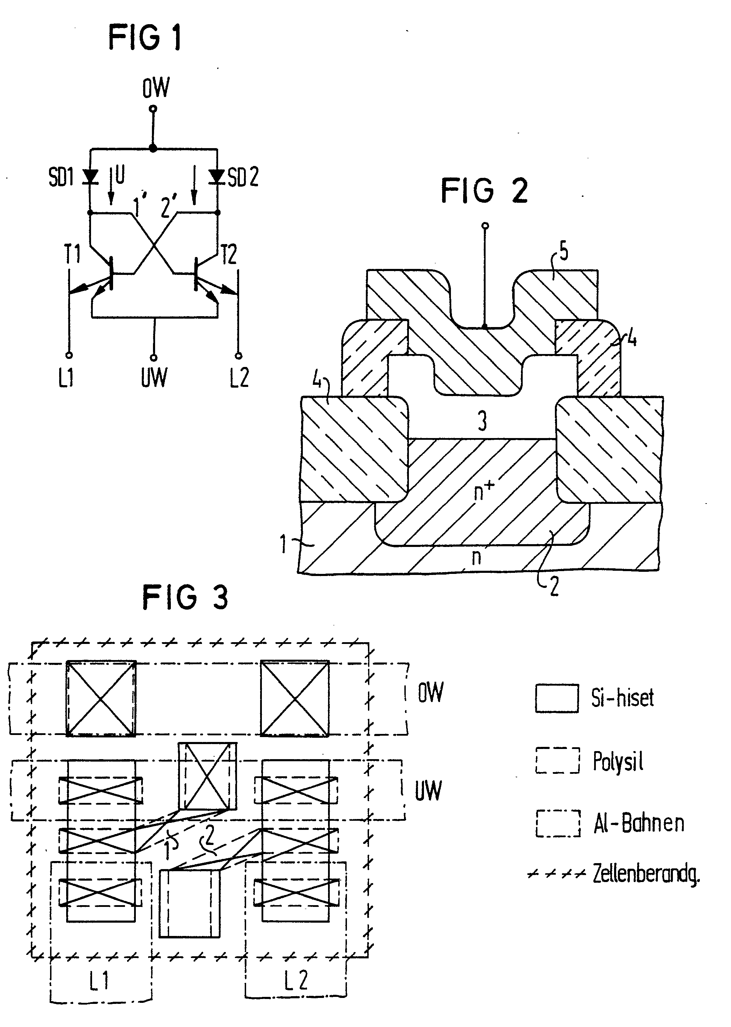

Dagegen spielt die Möglichkeit, die Schottkydioden auf einer — ihrerseits auf der den die Speicherzelle aufnehmenden Halbleiterkörper bedeckenden $SiO_2$-Schicht aufgebrachten Schicht aus polykristallinem Silicium zu erzeugen, um auf diese Weise an Chip-Fläche zu sparen, für die vorliegende Erfindung im allgemeinen keine Rolle, da es ersichtlich genügt, wenn man die für die betreffende Schottkydiode benötigte Schicht aus polykristallinem Silicium auf den einen Teil der Oberfläche der Kollektorzone beschränkt, während der Rest für die Kreuzkopplung zur Verfügung gehalten wird. Dieser Sachverhalt ist auch aus Figur 2 deutlich zu ersehen. Der Vorteil der Platzersparnis ist vielmehr dadurch bedingt, dass man durch Verwendung von auf einer polykristallinen Siliciumunterlage erzeugten Schottkydioden trotz des Fehlens der sonst erforderlichen Widerstände oder weiterer Schottkydioden diejenigen Nachteile mit Erfolg vermeidet, die in der DE-A-2 739 283 anhand von Figur 2 beschrieben werden.

Ein Ausführungsbeispiel der Erfindung wird nun anhand von Fig. 1 bis 3 näher beschrieben:

Fig. 1 stellt das Schaltbild einer Speicherzelle gemäss der Erfindung dar. Die beiden Transistoren T1 und T2 haben jeweils zwei Emitter, von denen der eine über eine dem Betrieb des Speichers dienende erste Leitung L1 bzw. L2 mit der jeweils zu speichernden Information beaufschlagt wird. Die beiden anderen Emitter der beiden Transistoren T1 und T2 sind miteinander verbunden und an einen gemeinsamen Versorgungsanschluss UW gelegt. Die Basis des Transistors T1 liegt am Kollektor des Transistors T2, die Basis des Transistors T2 liegt am Kollektor des Transistors T1. Ausserdem sind die Kollektoren der beiden Transistoren jeweils mit der Kathode einer Schottkydiode SD1 bzw. SD2 verbunden, die einander gleich sind und mit ihrer Anode an einem gemeinsamen weiteren Versorgungsanschluss OW liegen. (OW = obere Wortleitung, UW = untere Wortleitung an der Grenze der betreffenden Speicherzelle, während L1 und L2 die Rolle der linken und rechten Bitleitung am Rande der Zelle im Verband des Speichers erfüllen.

Für die Funktion der in Fig. 1 dargestellten Speicherzelle ist eine Stromcharakteristik für die Dioden SD1 und SD2 gemäss

$$(1) \qquad I = I_o (e^{\frac{U}{m \cdot U_T}} - 1)$$

angestrebt, wobei der Faktor $m > 1$ sein muss. Die Diodenspannung ist mit U bezeichnet. Die Spannung $U_T$ hat bei Zimmertemperatur den Wert von 0,025 V. Dioden mit dieser Charakteristik werden bevorzugt in der aus Fig. 2 ersichtlichen Weise realisiert.

Hier hat man an der Oberfläche des aus n-dotiertem monokristallinem Silicium bestehenden Kollektorbereichs 1 jedes der beiden Transistoren T1 bzw. T2 jeweils eine $n^+$-dotierte Zone 2 und auf dieser eine aus undotiertem Silicium bestehende polykristalline Schicht 3, welche ihrerseits einen aus einem geeigneten Metall, insbesondere aus Platin, bestehenden Schottkykontakt 5 trägt. Die aus $SiO_2$ bestehenden Isolierschichten an der freien Oberfläche des monokristallinen und des polykristallinen Siliciummaterials sind mit 4 bezeichnet. Die Strom-Spannungscharakteristik einer solchen Diode, deren Anode durch die Metallschicht und deren Kathode durch die polykristalline Siliciumschicht 3 mit daran anschliessender hochdotierter $n^+$-Einkristallschicht 2 gebildet ist, entspricht Gleichung (1) mit $m \geq 2$.

Die Erhöhung der Packungsdichte wird durch Verwendung einer solchen Schottkydiode als Lastelement und die Ausführung der Kreuzkopplungen 1' und 2' in Form von aus dotiertem polykristallinem Silicium bestehenden Leiterbahnen erreicht. Dabei wird das n⁺-diffundierte Kollektorgebiet jedes der beiden Transistoren mit dem p⁺-diffundierten Basiskontaktgebiet des jeweils anderen der beiden Transistoren T1 und T2 verbunden. (Einzelheiten bezüglich des Aufbaus der beiden Transistoren T1 und T2 sind weitgehend bekannt, so dass auf deren Darstellung verzichtet wurde.) Um die dabei entstehende Polysildiode n⁺p⁺ zu überbrücken, wird die Oberfläche dieser Diode mit einer Platinsilicidschicht überzogen (damit wird eine Dotierung der aus polykristallinem Silicium bestehenden Leiterbahnen 1', 2' überflüssig, da Platinsilicid ein guter Leiter ist), wozu zum Beispiel das in der Literaturstelle C. E. Weitzel und D. J. Tanguay «PtSi/Polysilicon Gate CMOS/SOS Transistors» in «Electrochemical Soc. Meeting» 1978 Abstr. No. 274 beschriebene Verfahren mit Erfolg angewendet werden kann. Die zur Bildung des Platinsilicids erforderliche Platinschicht kann ersichtlich gemeinsam mit dem Material der Elektroden 5 der beiden Schottkydioden SD1 und SD2 aufgebracht werden.

Mittels der angedeuteten Verfahrensschritte kann die Anzahl der erforderlichen Metallisierungsbahnen auf drei solcher Bahnen reduziert werden. Hierdurch und vor allem durch die angegebene Ausbildung der Schottkydioden SD1 und SD2 erreicht man eine beachtliche Einsparung an Chip-Fläche pro Speicherzelle und damit eine entsprechende Erhöhung der Packungsdichte bei der Vereinigung einer Vielzahl von solchen Speicherzellen in einer Speichermatrix monolitisch integrierter Bauart.

Als Beispiel wird das Layout einer entsprechenden Ausgestaltung einer Speicherzelle gemäss der Erfindung in Fig. 3 gebracht, das für minimale Strukturgrössen von 3 μm entwickelt wurde, wobei ein Metallisierungsraster von 7 μm Leiterbahnbreite und 2 μm Leiterbahnabstand zugrundegelegt sind. Weitere Reduktion der Strukturgrössen auf 2 μm ist ebenfalls möglich.

**Patentansprüche**

1. Integrierbare Halbleiterspeicherzelle mit zwei einander gleichen Bipolartransistoren, die derart geschaltet sind, dass ihre Kollektoren in Serie mit je einem eine nichtlineare Strom-Spannungscharakteristik aufweisenden Schaltungsteil an ein gemeinsames erstes elektrisches Versorgungspotential gelegt und ausserdem jeweils mit der Basis des jeweils anderen dieser beiden Transistoren verbunden sind, bei der ferner je ein Emitter dieser beiden Transistoren an einen gemeinsamen Anschluss für ein zweites Versorgungspotential gelegt und je ein weiterer Emitter zur Signalsteuerung der Halbleiterspeicherzelle vorgesehen ist, bei der ausserdem der zwischen dem Kollektor jedes der beiden Transistoren und dem das erste Versorgungspotential führenden Eingang liegende Schaltungsteil in allen Punkten seiner Stromspannungscharakteristik einen stärkeren Anstieg als die entsprechenden Punkte der Strom-Spannungscharakteristik des Emitter-Basis-Übergangs der beiden Transistoren hat, dadurch gekennzeichnet, dass in an sich bekannter Weise die beiden Schaltungsteile mit nichtlinearer Strom-Spannungscharakteristik jeweils nur aus eines Schottkydiode (SD1, SD2) bestehen, deren aus einer Metallelektrode (5) gebildete Anode zusammen mit der Anode der den anderen nichtlinearen Schaltungsteil bildenden Schottkydiode an dem das erste Versorgungspotential liefernden gemeinsamen Anschluss (OW) und deren Kathode (3) am Kollektor jeweils des einen und an der Basis des anderen Transistors (T1 bzw. T2) liegt, und dass die Kathode (3) der jeweiligen Schottky-Diode (SD1, SD2) aus polykristallinem Halbleitermaterial erzeugt wird.

2. Halbleiterspeicherzelle nach Anspruch 1, dadurch gekennzeichnet, dass die beiden Schottkydioden (SD1, SD2) auf einer aus undotiertem Halbleitermaterial bestehenden Unterlage erzeugt sind.

3. Halbleiterspeicherzelle nach Anspruch 1 oder 2, dadurch gekennzeichnet, dass die polykristalline Halbleiterschicht, insbesondere Siliciumschicht, an der Oberfläche eines hochdotierten Bereichs (2) an der Oberfläche der Kollektorzone (1) jedes der beiden Transistoren (T1, T2) niedergeschlagen und an der von dem einkristallinen Bereich abgewandten Seite mit einer den Schottkykontakt bildenden Metallschicht (5) versehen ist.

4. Halbleiterspeicherzelle nach den Ansprüchen 1 bis 3, dadurch gekennzeichnet, dass die beiden Transistoren (T1, T2) der Speicherzelle als npn-Transistoren in einer einkristallinen Siliciumschicht, insbesondere als Vertikaltransistoren ausgebildet sind.

5. Halbleiterspeicherzelle nach den Ansprüchen 1 bis 4, dadurch gekennzeichnet, dass als Material für den Kontakt (5) der beiden Schottkydioden (SD1, SD2) Platinsilicid verwendet ist.

6. Halbleiterspeicherzelle nach den Ansprüchen 1 bis 5, dadurch gekennzeichnet, dass die Kreuzkopplung der beiden Transistoren (T1, T2) der Speicherzelle mittels aus polykristallinem Silicium gebildeten Leiterbahnen (1', 2') besteht, die wenigstens an ihrer Oberfläche in Platinsilicid umgewandelt sind.

**Claims**

1. An integratable semiconductor storage cell having two similar bipolar transistors so connected that their collectors are each connected in series with a respective circuit element having a non-linear current-voltage characteristic, to a common first electrical supply potential, and which are also each connected to the base of the respective other of the two transistors, in which, moreover, an emitter of each of the two transistors is connected to a common terminal for a second supply potential and in each case a further emitter is provided for signal control of the semiconductor storage cell, wherein furthermore each circuit element arranged between the collector of a respective one of the two transistors and the input carrying the first supply potential has a steeper rise at all points of its current-voltage characteristic than have the corresponding points of the current-voltage characteristic of the emitter-base-junction of the two transistors, characterised in that, in known manner, the two circuit elements having a non-linear current-voltage characteristic each consist of one Schottky diode only (SD1, SD2), the anode of the Schottky diode, which is in the form of a metal electrode (5), together with the anode of the Schottky diode forming the other non-linear circuit anode being connected to the common terminal (DW) which supplies the first supply potential, and the cathode (3) of the Schottky diode being connected to the collector of the one and to the base of the other transistor (T1 or T2, as the case may be); and that the cathodes (3) of the respective Schottky diodes (SD1, SD2) are produced from polycrystalline semiconductor material.

2. A semiconductor storage cell according to claim 1, characterised in that the two Schottky diodes (SD1, SD2) are produced an a substrate consisting of undoped semiconductor material.

3. A semiconductor storage cell according to claim 1 or claim 2, characterised in that the polycrystalline semiconductor layer, in particular a silicon layer, is deposited at the surface of a highly-doped region (2) at the surface of the collector zone (1) of each of the two transistors (T1, T2), and is provided with a metal layer (5), which forms the Schottly contact, on the side facing away from the monocrystalline region.

4. A semiconductor storage cell according to claims 1 to 3, characterised in that the two transistors (T1, T2) of the storage cell are constructed as npn-transistors in a monocrystalline silicon layer, in particular as vertical transistors.

5. A semiconductor storage cell according to claims 1 to 4, characterised in that platinum silicide is used as the material for the contact (5) of the two Schottky diodes (SD1, SD2).

6. A semiconductor storage cell according to claims 1 to 5, characterised in that the cross-coupling of the two transistors (T1, T2) of the storage cell is effected by means of conductor paths (1', 2') which consist of polycrystalline silicon, and which, at least at their surface are converted into platinum silicide.

**Revendications**

1. Cellule de mémoire intégrable à semiconducteurs comportant deux transistors bipolaires identiques qui sont montés de manière que leurs collecteurs, respecitvement une partie de circuit présentant une caractéristique courant-tension non linéaire, soient reliés à un premier potentiel d'alimentation électrique commun, et en outre soient respectivement reliés à la base de l'autre de ces deux transistors respectifs, dans laquelle de plus un émetteur de ces deux transistors est respectivement relié à une borne commune pour un second potentiel d'alimentation et un autre émetteur respectif est prévu pour la commande de signaux de la cellule de mémoire à semiconducteurs, dans laquelle en outre la partie de circuit se trouvant entre le collecteur de chacun des deux transistors et l'entrée délivrant le premier potentiel d'alimentation présente, pour tous les points de sa caractéristique courant-tension, une montée plus forte que les points correspondants de la caractéristique courant-tension de la jonction émetteur-base des deux transistors, caractérisée par le fait que, de façon connue en soi, les deux parties de circuit présentant une caractéristique courant-tension non linéaire ne sont constituées respectivement que par une diode Schottky (SD1, SD2) dont l'anode, formée par une électrode métallique (5), conjointement avec l'anode de la diode Schottky constituant l'autre partie de circuit non linéaire, est reliée à la borne commune (OW) délivrant le premier potentiel d'alimentation, et dont la cathode (3) est respectivement reliée au collecteur de l'un des transistors et à la base de l'autre transsistor (T1 ou respectivement T2), et que la cathode (3) de la diode Schottky respective (SD1, SD2) est formée par un matériau semiconducteur polycristallin.

2. Cellule de mémoire à semiconducteurs suivant la revendication 1, caractérisée par le fait que les deux diodes Schottky (SD1, SD2) sont formées sur un substrat constitué par un matériau semiconducteur non dopé.

3. Cellule de mémoire à semiconducteurs suivant la revendication 1 ou 2, caractérisée par le fait que la couche semiconductrice polycristalline, notamment une couche de silicium, est déposée sur la surface d'une région fortement dopée (2) au niveau de la surface de la zone de collecteur (1) de chacun des deux transistors (T1, T2), et est munie, du côté opposé à la région monocristalline, d'une couche métallique (5) formant le contact Schottky.

4. Cellule de mémoire à semiconducteurs suivant les revendications 1 à 3, caractérisée par le fait que les deux transistors (T1, T2) de la cellule de mémoire se présentent sous la forme de transistors npn dans une couche de silicium monocristallin, notamment sous la forme de transistors verticaux.

5. Cellule de mémoire à semiconducteurs suivant les revendications 1 à 4, caractérisée par le fait qu'on utilise du siliciure de platine en tant que matériau pour le contatc (5) des deux diodes Schottky (SD1, SD2).

6. Cellule de mémoire à semiconducteurs suivant les revendications 1 à 5, caractérisée par le fait que le montage croisé des deux transistors (T1, T2) de la cellule de mémoire est formé au moyen de voies conductrices (1', 2') formées par du silicum polycristallin, qui sont transformées en siliciure de platine au moins au niveau de leur surface.

# FIG 1

# FIG 2

# FIG 3

Si-hiset

Polysil

Al-Bahnen

Zellenberandg.